# EUROPEAN PATENT APPLICATION

(11) **EP 4 703 856 A1**
(43) Date of publication of application: **04.03.2026**
(21) Application number: 25190891.9
(22) Date of filing: 22.07.2025
(51) Int. Cl.: G06F 3/041, G06F 3/044

(54) **DISPLAY DEVICE**

(30) Priority: 30.08.2024 KR 20240117946
(71) Applicant: LG Display Co., Ltd., Seoul, 07336 (KR)
(72) Inventor: HAN, Surin, 10845 Paju-si (KR); KANG, ChangHeon, 10845 Paju-si (KR); HAN, Jonghyun, 10845 Paju-si (KR); KYOUNG, Kyuwon, 10845 Paju-si (KR); JEONG, Seongwoong, Paju-si (KR); MOON, Younggyu, Paju-si (KR)
(74) Representative: Morrall, Jonathan Ian McLachlan

(57) **Abstract**

A display device can include a substrate having a display area and a non-display area outside the display area, a thin film transistor on the substrate, a subpixel connected to the thin film transistor, an encapsulation layer disposed on the subpixel, a first sensor electrode disposed on the encapsulation layer, a touch interlayer insulation layer disposed on the first sensor electrode, and a second sensor electrode disposed on the touch interlayer insulation layer. The second sensor electrode is electrically connected to the first sensor electrode through a contact hole of the touch interlayer insulation layer.

## Description

### CROSS-REFERENCE TO RELATED APPLICATION

This application claims priority to Korean Patent Application No. 10-2024-0117946, filed in the Republic of Korea on August 30, 2024, which is hereby expressly incorporated by reference for all purposes as if fully set forth herein into the present application.

### BACKGROUND

### Field

The disclosure relates to a display device.

### Discussion of Related Art

The advent of the information age leads to a fast advance in the field of displays which visually display electrical information signals. As such, steady research efforts to develop compact and lightweight, low-power displays while enhancing the performance of displays are ongoing.

Example display devices include liquid crystal displays (LCD), electro-wetting displays (EWD), and organic light emitting displays (OLED).

Among the display devices, electroluminescent display devices, as self-luminous, do not require a separate light source, unlike liquid crystal displays, and can be manufactured in a slim and lightweight form. Further, electroluminescent display devices are not only advantageous in terms of power consumption due to low-voltage operation, but also have excellent color expression, response speed, viewing angle, contrast ratio, and contrast ratio (CR), and are thus expected to be utilized in various fields.

### SUMMARY OF THE DISCLOSURE

Embodiments of the disclosure can provide a display device with an increased degree of freedom in arrangement of touch electrodes.

Embodiments of the disclosure can provide a display device with enhanced touch sensing capability.

A display device according to embodiments of the disclosure can comprise a substrate including a display area and a non-display area outside the display area, a thin film transistor on the substrate, a subpixel connected to the thin film transistor, an encapsulation layer disposed on the subpixel, a first sensor electrode formed of the same layer as a first sensor electrode layer on the encapsulation layer, a touch interlayer insulation layer disposed on the first sensor electrode layer, and a second sensor electrode formed of the same layer as a second sensor electrode layer on the touch interlayer insulation layer and electrically connected to the first sensor electrode through a contact hole of the touch interlayer insulation layer.

A display device according to embodiments of the disclosure can comprise a substrate, a plurality of sensor electrodes, and a black matrix on the plurality of sensor electrodes. The black matrix can include a first portion having a first width and a second portion having a second width larger than the first width. The plurality of sensor electrodes can include a first sensor electrode overlapping the first portion and a second sensor electrode overlapping the second portion. The first sensor electrode can be positioned closer to the substrate than the second sensor electrode.

According to embodiments of the disclosure, there can be provided a display device capable of minimizing defects caused by light by including different touch sensor layers in a display area.

According to embodiments of the disclosure, there can be provided a display device having a degree of freedom in design of an upper black matrix by applying an insulation layer capable of planarizing an upper touch electrode between touch sensor layers.

Objects of the disclosure are not limited to the foregoing, and other unmentioned objects would be apparent to one of ordinary skill in the art from the following description.

### DESCRIPTION OF THE DRAWINGS

The above and other objects, features, and advantages of the disclosure will be more clearly understood from the following detailed description, taken in conjunction with the accompanying drawings, in which:
FIG. 1 is a plan view illustrating a display device according to an embodiment of the disclosure;
FIG. 2 is an exploded perspective view illustrating a disposition structure of a touch electrode in a display device according to an embodiment of the disclosure;
FIG. 3 is a plan view illustrating a structure of a touch electrode disposed on a touch sensor layer according to an embodiment of the disclosure;
FIG. 4 is a plan view illustrating a touch sensor, with portion X1 of FIG. 3 enlarged;
FIG. 5 is a cross-sectional view taken along line A-A' of FIG. 4;
FIG. 6 is a cross-sectional view taken along line C-C' of FIG. 4;
FIG. 7 is a cross-sectional view taken along line B-B' of FIG. 4;
FIG. 8 is a plan view illustrating a display device according to an embodiment of the disclosure;
FIG. 9 is a plan view illustrating a display device according to an embodiment of the disclosure;
FIG. 10 is a cross-sectional view taken along line D-D' of FIG. 8;
FIG. 11 is a cross-sectional view taken along line E-E' of FIG. 8; and
FIG. 12 is a cross-sectional view taken along line F-F' of FIG. 8.

### DETAILED DESCRIPTION OF THE EMBODIMENTS

Some embodiments of the disclosure are described in detail below with reference to example drawings. In assigning reference numerals to components of each drawing, the same components can be assigned the same numerals even when they are shown on different drawings. When determined to make the subject matter of the disclosure unclear, the detail of the known art or functions can be skipped. As used herein, when a component "includes," "has," or "is composed of" another component, the component can add other components unless the component "only" includes, has, or is composed of" the other component. As used herein, the singular forms "a", "an" and "the" are intended to include the plural forms as well, unless the context clearly indicates otherwise.

Further, in describing the components of the disclosure, terms, such as first, second, A, B, (a), and (b), can be used. These denotations are provided merely to distinguish a component from another, and the essence, order, or number of the components are not limited by the denotations.

In describing the positional relationship between components, when two or more components are described as "connected", "coupled" or "linked", the two or more components can be directly "connected", "coupled" or "linked" ", or another component can intervene. Here, the other component can be included in one or more of the two or more components that are "connected", "coupled" or "linked" to each other.

When such terms as, e.g., "after", "next to", "after", and "before", are used to describe the temporal flow relationship related to components, operation methods, and fabricating methods, it can include a non-continuous relationship unless the term "immediately" or "directly" is used. Further, the term "can" fully encompasses all the meanings and coverages of the term "may" and vice versa.

When a component is designated with a value or its corresponding information (e.g., level), the value or the corresponding information can be interpreted as including a tolerance that can arise due to various factors (e.g., process factors, internal or external impacts, or noise).

Hereinafter, various embodiments of the disclosure are described in detail with reference to the accompanying drawings. All the components of each display device/apparatus according to all embodiments of the disclosure are operatively coupled and configured.

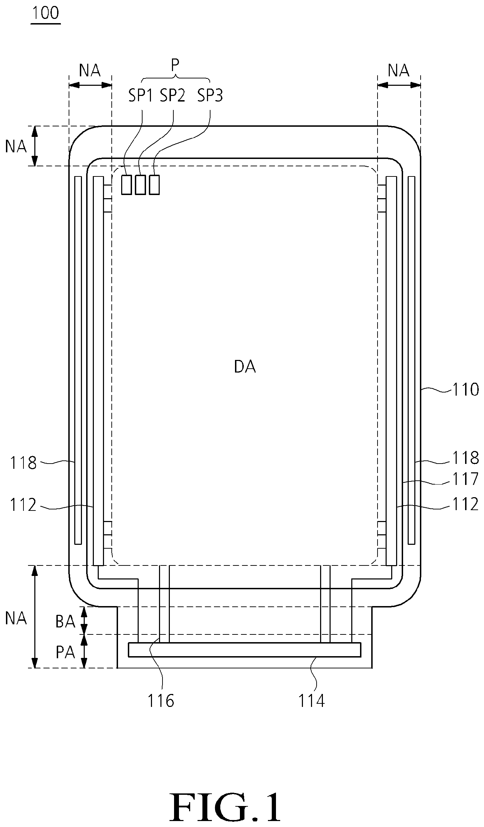

FIG. 1 is a plan view illustrating a display device according to an embodiment of the disclosure.

Referring to FIG. 1, a display device 100 according to an embodiment of the disclosure can include a substrate 110.

The substrate 110 can be configured to support various components included in the display device 100. The substrate 110 can be formed of an insulating material. Further, the substrate 110 can be formed of a transparent material. Further, the substrate 110 can be a rigid substrate or a flexible substrate capable of bending, folding, and rolling. Further, the substrate 110 can be formed of glass or a plastic material having flexibility. For example, if the substrate 110 is formed of polyimide PI which is a plastic material, the manufacturing process of the display device 100 can proceed in a circumstance where a support substrate formed of glass is disposed under the substrate 110, and the support substrate can be released after the manufacturing process of the display device 100 is completed. When the substrate 110 is formed of double layers of polyimide (PI) which is a plastic material, an insulation layer can be formed between the substrates 110 which are the double layers. The insulation layer between the substrates 110 can include an inorganic material. For example, the insulation layer between the substrates 110 can include silicon oxide (SiOx) or silicon nitride (SiNx), but is not limited thereto.

The substrate 110 of the display device 100 can be defined as a display area DA and a non-display area NA which is outside the display area DA and in which a plurality of pixels P are not disposed. The non-display area NA can be adjacent to the display area DA, but can be disposed outside the display area DA.

The display area DA of the substrate 110 can be an area in which pixels P are disposed to display an image. A plurality of subpixels SP1, SP2, and SP3 can be disposed in the display area DA, and a plurality of subpixels SP1, SP2, and SP3 can constitute one pixel P.

For example, one or each pixel P can include three or more subpixels SP that emit light of wavelengths implementing different colors. For example, in the display device 100 according to an embodiment of the disclosure, one pixel P can include subpixels SP that emits red, green, and blue light. However, the number of subpixels SP included in one pixel P is not limited, and for example, a subpixel SP emitting white light can be further included in addition to the subpixels SP emitting red, green, and blue light.

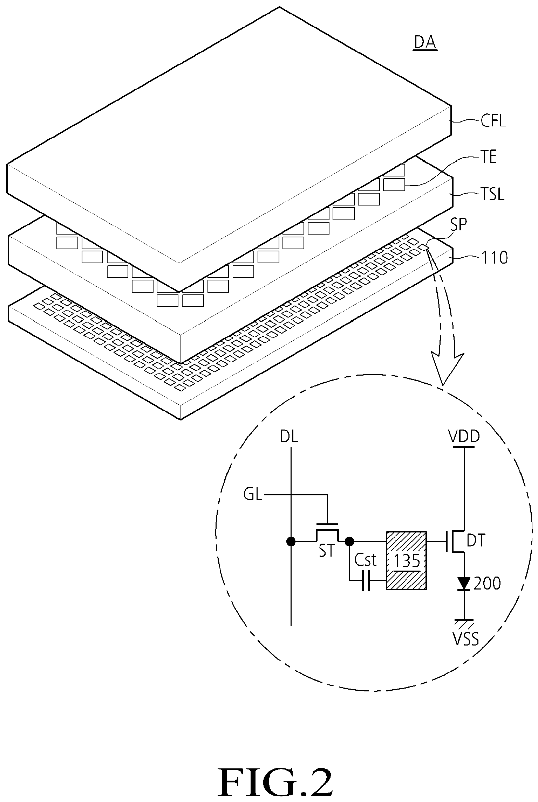

The non-display area NA of the substrate 110 can be defined as a peripheral area surrounding the display area DA, a bending area BA extending and bending from one side of the peripheral area, and a pad area PA extending from the bending area BA. FIG. 2 illustrates a state of the substrate 110 before bending.

The non-display area NA of the substrate 110 is an area in which various lines, circuits, or the like for driving the subpixels SP1, SP2, and SP3 disposed in the display area DA are disposed. Since the non-display area NA is not an area in which an image is displayed, it need not be visually recognized from the front of the display device 100. Accordingly, a partial area of the non-display area NA of the substrate 110 can be bent toward the rear surface of the display device 100, e.g., bent in the direction of the rear surface of the display device 100 so that one edge of the substrate 110 has a predetermined curvature. In this case, the pad area PA can be positioned to overlap the display area DA on the rear surface of the display device 100. Accordingly, the non-display area NA can be reduced while securing an area for lines and driving circuits.

When the substrate 110 includes an insulation layer in polyimide PI, which is a plastic material, the insulation layer in the polyimide PI may not be disposed in the bending area BA. For example, in the bending area BA, the substrate 110 may not include an insulation layer in the polyimide PI, or the insulation layer can be patterned. For example, if an insulation layer including an inorganic material is included in the bending area BA, stress can be concentrated in the insulation layer including the inorganic material, resulting in cracks.

The pad portion 114 can be disposed in the pad area PA of the substrate 110. The pad portion 114 can be a metal pattern bonded to an external module, e.g., a flexible printed circuit board (FPCB), a chip on film (COF), or the like. Although FIG. 2 illustrates that the pad portion 114 is disposed on one side of the non-display area NA, the shape and the disposition position thereof are not limited thereto.

Further, a connection line 116 can be disposed in a portion of the non-display area NA of the substrate 110. For example, the connection line 116 can be disposed in an area adjacent to the bending area BA in a peripheral area of the substrate 110.

The connection line 116 can transmit a signal (e.g., a voltage) from an external module bonded to the pad portion 114 to a circuit unit such as the gate driving unit 112 included in the display area DA or the gate driver. The gate driving unit 112 provides a gate signal to a thin film transistor of a pixel driving circuit and includes various gate driving circuits. In the display device 100 according to an embodiment of the disclosure, the gate driving unit 112 can be a gate-in-panel (GIP) in which gate driving circuits are directly formed on the substrate 110.

Various signals and voltages such as a gate signal, a data signal, a high-potential voltage, and a low-potential voltage can be transmitted through the connection line 116. The connection line 116 can be classified into a power connection line and/or a signal connection line according to a transmitted voltage and/or signal. In this case, the power connection line can transmit a voltage supplied from the external module to the display area DA. The power connection line can be connected to the low-potential voltage line VSS, the high-potential voltage line VDD, and the gate low-voltage line and/or gate high-voltage line included in the gate driving unit 112, but is not limited thereto. Further, the signal connection line can transmit a signal for image display supplied from an external module to the display area DA. The signal connection line can be connected to the gate line and/or the data line, but is not limited thereto.

Further, a dam 117 can be disposed in the non-display area NA of the substrate 110 to surround the whole or portion of the display area DA. In this case, the dam 117 can be disposed adjacent to the display area DA, but can be disposed outside the display area DA. The dam 117 can be disposed along the periphery of the display area DA to control the flow of a layer including an organic material among the encapsulation layers disposed on the light emitting element. The number of dams 117 can be one or more.

Further, a crack detection line (panel crack detector) 118 can be further disposed in an area of the non-display area NA of the substrate 110. The crack detection line 118 can be disposed between an end point (or an end) of the substrate 110 and the dam 117. Further, the crack detection line 118 can be disposed under the dam 117 to at least partially overlap the dam 117. The crack detection line 118 can be disposed outside the display device 100 to detect defects such as cracks that can occur outside the display device 100.

Further, the display device 100 according to an embodiment of the disclosure can further include a touch detection unit including a plurality of touch electrodes and a touch sensing circuit supplying a touch driving signal to the touch detection unit and sensing the presence or absence of the user's touch and touch position (or coordinates) by detecting a touch sensing signal from the touch detection unit.

For example, the touch sensing circuit can include, e.g., a touch driving circuit supplying a touch driving signal to the touch detection unit and detecting a touch sensing signal from the touch detection unit and a touch controller sensing the presence or absence of the user's touch and/or touch position based on the touch sensing signal detected by the touch driving circuit. The touch driving circuit and the touch controller can be implemented as separate components, or in some cases, can be integrated into one component.

One or more of the circuit components for touch sensing and one or more of the components for display driving can be functionally integrated to be implemented as one or more components. For example, the data driver and the touch driving circuit can be implemented by being integrated into one or more integrated circuit chips. When the data driver and the touch driving circuit are implemented to be integrated into two or more integrated circuit chips, each of the two or more integrated circuit chips can have a data driving function and a touch driving function.

FIG. 2 is an exploded perspective view illustrating a disposition structure of a touch electrode in a display device according to an embodiment of the disclosure.

Referring to FIG. 2, the display device 100 according to an embodiment of the disclosure can include a substrate 110 on which a plurality of subpixels SP are disposed in the display area DA, and a touch electrode layer TSL disposed on the substrate 110 and including a plurality of touch electrodes TE. Further, the display device 100 can include a color filter layer CFL disposed on the touch electrode layer TSL and including a plurality of color filters and a black matrix between color filters on a plane.

The display area DA of the substrate 110 is an area in which a plurality of pixels implementing an image are disposed, and one pixel can include a plurality of subpixels SP each including a light emitting element 200 and a pixel driving circuit for controlling the amount of current flowing to the light emitting element 200. The pixel driving circuit can include a plurality of thin film transistors TFT.

In an embodiment of the disclosure, it is assumed that the display device 100 is an organic light emitting display device, but the disclosure is not limited thereto. For example, when the display device 100 is an organic light emitting display device, the subpixel can include a light emitting element 200 including an anode electrode, a light emitting layer on the anode electrode, and a cathode electrode on the light emitting layer. In this case, the light emitting element 200 can include an organic light emitting layer as the light emitting layer, and can further include a hole transport layer, a hole injection layer, an electron injection layer, and an electron transport layer along with the organic light emitting layer. Meanwhile, as another example, when the display device 100 is a liquid crystal display device, it can be configured to include a liquid crystal layer that is a display unit.

The pixel driving circuit of the subpixel SP according to an embodiment of the disclosure can include a driving transistor DT, a switching transistor ST, a capacitor Cst, a gate line GL, a data line DL, and a line connected to a power source VDD and VSS for pixel driving.

The light emitting element 200 can operate to emit light according to a driving current formed by the driving transistor DT. The switching transistor ST can perform a switching operation so that the data signal supplied through the data line DL is stored as a data voltage in the capacitor Cst in response to the gate signal supplied through the gate line GL. The driving transistor DT can operate so that a predetermined driving current flows between the high-potential power source VDD and the low-potential power source VSS in response to the data voltage stored in the capacitor Cst.

An example has been described above that in the display device 100 according to an embodiment of the disclosure, the subpixel SP is configured in a 2T (transistor) 1C (capacitor) structure including one switching transistor ST, one driving transistor DT, and one capacitor Cst.

As another example, as illustrated in FIG. 2, the subpixel can further include a compensation circuit 135.

The compensation circuit 135 is a circuit for compensating for the threshold voltage of the driving transistor DT, and the compensation circuit 135 can include one or more thin film transistors and a capacitor. In this case, the configuration and structure of the compensation thin film transistor and the compensation capacitor are not limited, but can vary according to a compensation method. For example, when the compensation circuit 135 is added to the subpixel, it can have various structures such as 3T1C, 4T2C, 5T2C, 6T1C, 6T2C, 7T1C, 7T2C or the like.

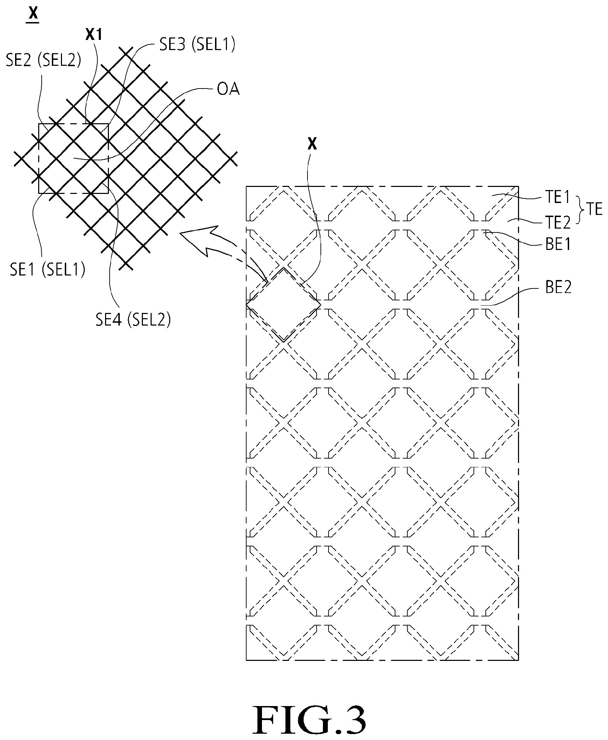

FIG. 3 is a plan view illustrating a structure of a touch electrode disposed on a touch electrode layer according to an embodiment of the disclosure.

Referring to FIG. 3, the display device 100 can include a plurality of touch electrodes TE and bridge electrodes BE1 and BE2 electrically connecting the sensor electrodes of the plurality of touch electrodes TE.

For example, each of the plurality of touch electrodes TE can include a plurality of first touch electrodes TE1 extending in a first direction and a plurality of second touch electrodes TE2 extending in a second direction crossing the first direction. In this case, a plurality of first touch routing lines respectively connected to the plurality of first touch electrodes TE1, a plurality of second touch routing lines respectively connected to the plurality of second touch electrodes TE2, and a plurality of touch pads respectively connected to the plurality of first and second touch routing lines can be further disposed on the substrate 110.

Each of the plurality of first touch electrodes TE1 and the plurality of second touch electrodes TE2 can include a plurality of touch sensors SE1, SE2, SE3, and SE4. Although FIG. 3 illustrates that the second touch electrode TE2 has a shape in which sensor electrodes formed in a rhombus-shaped mesh pattern are consecutively formed, the disclosure is not limited thereto, and the sensor electrode can have various shapes such as a triangle, a square, a rhombus, and a polygon. For example, each of the first touch electrode TE1 and the second touch electrode TE2 can include a plurality of sensor electrodes patterned in a mesh shape.

The plurality of sensor electrodes SE1, SE2, SE3, and SE4 can be formed in a mesh pattern and can include an opening OA. The openings OA of the plurality of sensor electrodes SE1, SE2, SE3, and SE4 can overlap and the subpixel SP.

The plurality of sensor electrodes SE1, SE2, SE3, and SE4 can be formed on different touch sensor electrode layers SEL1 and SEL2. For example, the plurality of sensor electrodes SE1, SE2, SE3, and SE4 can be formed on the first touch sensor layer SEL1 or the second touch sensor layer SEL2. The related description is presented below.

The display device 100 can include a plurality of touch electrodes TE, as illustrated in X of FIG. 3, and each of the plurality of touch electrodes TE can include a plurality of sensor electrodes SE, as illustrated in X1 of FIG. 3.

The display device 100 according to an embodiment of the disclosure can sense a touch using a mutual-capacitance-based touch sensing method, or can sense a touch using a self-capacitance-based touch sensing method.

In the case of a mutual-capacitance-based touch sensing method, the plurality of touch electrodes TE can be classified into a driving touch electrode to which a touch driving signal is applied, and a sensing touch electrode in which a touch sensing signal is detected and which forms a capacitance with the driving touch electrode. For example, the first touch electrode TE1 can be a sensing touch electrode in which a touch sensing signal is sensed, and in this case, the second touch electrode TE2 can be a driving touch electrode to which a touch driving signal is applied, but is not limited thereto. In other words, the first touch electrode TE1 can be a driving touch electrode, and the second touch electrode TE2 can be a sensing touch electrode.

In the case of a self-capacitance-based touch sensing method, the plurality of touch electrodes TE serve as both a driving touch electrode and a sensing touch electrode. In other words, the touch sensing circuit applies a touch driving signal to one or more touch electrodes TE, detects a touch sensing signal through the touch electrode TE to which the touch driving signal is applied, and senses the presence or absence of a touch and/or touch coordinates by identifying a change in capacitance between a pointer such as a finger or pen and the touch electrode TE based on the detected touch sensing signal. In the self-capacitance-based touch sensing scheme, no distinction is made between the driving touch electrode and the sensing touch electrode. For example, a plurality of first touch electrodes TE1 and a plurality of second touch electrodes TE2 each can serve as both a driving touch electrode and a sensing touch electrode.

Although an example of the structure of the sensor electrode of the first touch electrode TE1 has been described above, the sensor electrode of the second touch electrode TE2 can also have the same structure.

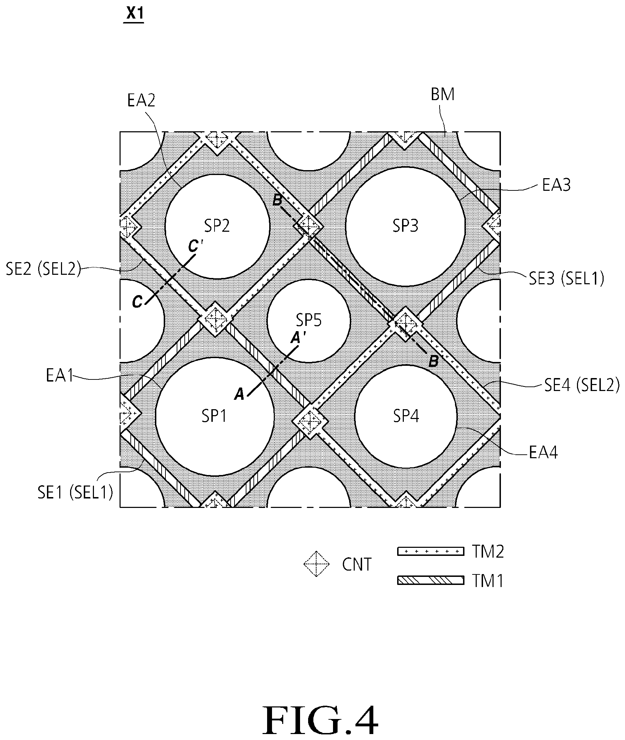

FIG. 4 is a plan view illustrating a sensor electrode, with portion X1 of FIG. 3 enlarged.

Referring to FIG. 4, the display device 100 can include a sensor electrode SE. The sensor electrode SE can include a first sensor electrode SE1, a second sensor electrode SE2, a third sensor electrode SE3, and a fourth sensor electrode SE4. The first sensor electrode SE1, the second sensor electrode SE2, the third sensor electrode SE3, and the fourth sensor electrode SE4 can be formed on the subpixel SP, and can be formed in a mesh shape.

The shape of the first sensor electrode SE1 and the shape of the second sensor electrode SE2 can be the same. For example, the first sensor electrode SE1 and the second sensor electrode SE2 can have a rhombus shape.

The size of the first sensor electrode SE1 and the size of the second sensor electrode SE2 can correspond to each other. The size of the first sensor electrode SE1 and the size of the second sensor electrode SE2 can correspond to the width of the opening of the first sensor electrode SE1 and the width of the opening of the second sensor electrode SE2, respectively.

The subpixel SP can include a first subpixel SP1, a second subpixel SP2, a third subpixel SP3, and a fourth subpixel SP4. For example, the first sensor electrode SE1 can correspond to the first subpixel SP1, the second sensor electrode SE2 can correspond to the second subpixel SP2, the third sensor electrode SE3 can correspond to the third subpixel SP3, and the fourth sensor electrode SE4 can correspond to the fourth subpixel SP4.

A black matrix BM can be formed on the sensor electrode SE. The black matrix BM can include a plurality of openings corresponding to the emission area EA of the plurality of subpixels SP. For example, the opening of the black matrix BM corresponding to the first subpixel SP1 can be a first emission area EA1, the opening of the black matrix BM corresponding to the second subpixel SP2 can be a second emission area EA2, the opening of the black matrix BM corresponding to the third subpixel SP3 can be a third emission area EA3, and the opening of the black matrix BM corresponding to the fourth subpixel SP4 can be a fourth emission area EA4.

The plurality of subpixels SP can have different pixel structures. For example, the first subpixel SP1 and the third subpixel SP3 can correspond to blue (B) subpixels. For example, the second subpixel SP2 and the fourth subpixel SP4 can correspond to red (R) subpixels.

The fifth subpixel SP5 can be disposed in a shape surrounded by the first subpixel SP1, the second subpixel SP2, the third subpixel SP3, and the fourth subpixel SP4. For example, the fifth subpixel SP5 can be disposed in a shape surrounded by the first sensor electrode SE1, the second sensor electrode SE2, the third sensor electrode SE3, and the fourth sensor electrode SE4. The opening of the black matrix BM corresponding to the fifth subpixel SP5 can be a fifth emission area EA5. The fifth emission area EA5 can be smaller than the first emission area EA1, the second emission area EA2, the third emission area EA3, and the fourth emission area EA4.

The first sensor electrode SE1 and the third sensor electrode SE3 can be formed of a first touch metal TM1, and the second sensor electrode SE2 and the fourth sensor electrode SE4 can be formed of a second touch metal TM2. The first touch metal TM1 can be formed of the same layer as the first sensor electrode layer SEL1, and the second touch metal TM2 can be formed of the same layer as the second sensor electrode layer SEL2.

Each of the first subpixel SP1, the second subpixel SP2, the third subpixel SP3, and the fourth subpixel SP4 can be surrounded by the same touch metal. For example, the first subpixel SP1 and the third subpixel SP3 can be surrounded by the first touch metal TM1 formed of the same layer as the first sensor electrode layer SEL1, and the second subpixel SP2 and the fourth subpixel SP4 can be surrounded by the second touch metal TM2 formed of the same layer as the second sensor electrode layer SEL2.

The fifth subpixel SP5 can be surrounded by different touch metals. For example, the fifth subpixel SP5 can be surrounded by the first touch metal TM1 formed of the same layer as the first sensor electrode layer SEL1 and the second touch metal TM2 formed of the same layer as the second sensor electrode layer SEL2.

As the plurality of subpixels SP can have different pixel structures, the opening of the black matrix BM can have different shapes according to the emission areas of the blue subpixel, the green subpixel, and the red subpixel, but are not limited thereto. For example, the opening of the black matrix BM can have different shapes according to the emission area EA. For example, the first subpixel SP1 can be larger than the second subpixel SP2. Accordingly, the opening of the black matrix BM corresponding to the first subpixel SP1 can be larger than the opening of the black matrix BM corresponding to the second subpixel SP2, but the disclosure is not limited thereto.

The first sensor electrode SE1 and the second sensor electrode SE2 can be formed of different layers. For example, the first sensor electrode SE1 can be formed under the second sensor electrode SE2. For example, the first sensor electrode SE1 can be formed on the first sensor electrode layer SEL1, and the second sensor electrode SE2 can be formed on the second sensor electrode layer SEL2. An example in which the sensor electrodes SE can be formed of different layers is described below.

The first sensor electrode SE1 and the second sensor electrode SE2 can be connected to each other through a contact hole CNT. For example, the first sensor electrode SE1 and the second sensor electrode SE2 can be electrically connected to each other through a contact hole CNT.

Although the relationship between the first sensor electrode SE1 and the second sensor electrode SE2 has been described according to embodiments of the disclosure, the disclosure is not limited thereto. For example, the third sensor electrode SE3 and the fourth sensor electrode SE4 can be formed of different layers, and the third sensor electrode SE3 can be formed lower than the fourth sensor electrode SE4.

The effect of forming the first sensor electrode SE1 and the second sensor electrode SE2 with different layers is described below.

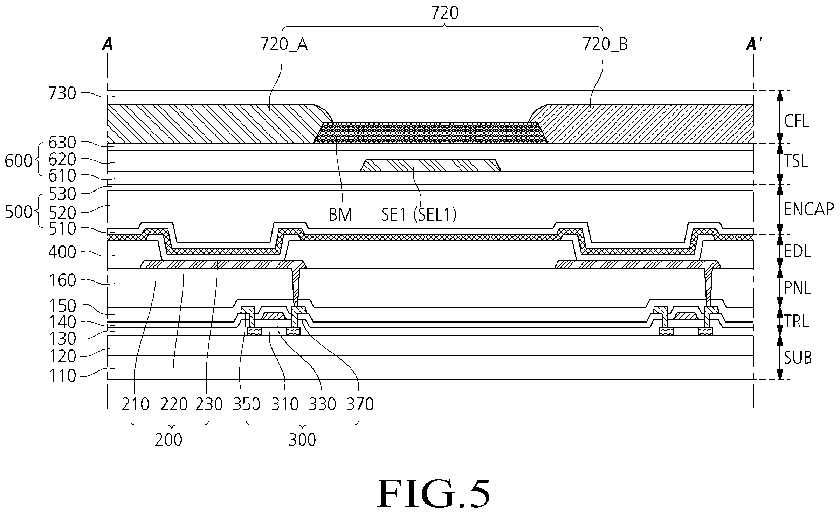

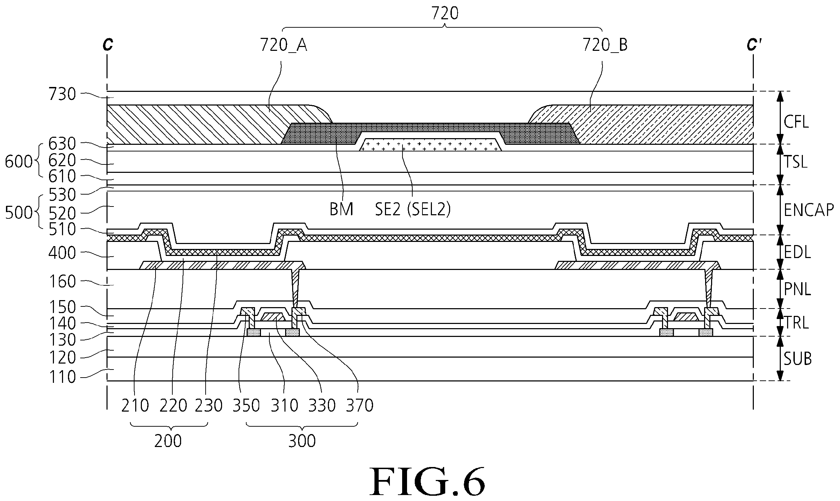

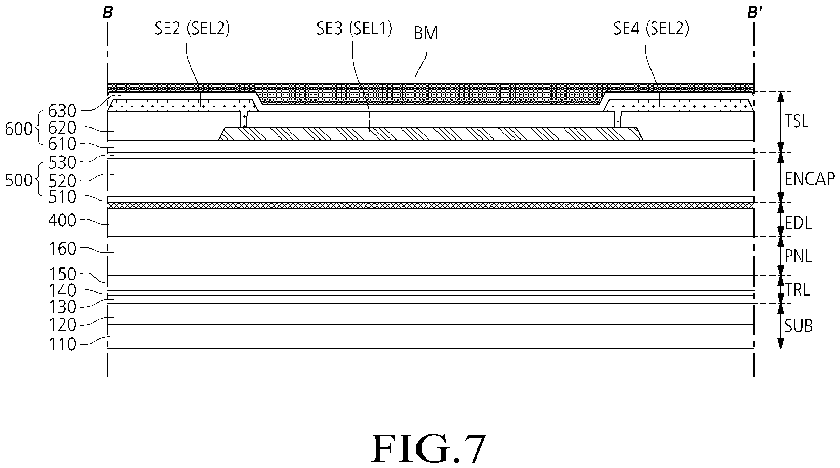

FIG. 5 is a cross-sectional view taken along line A-A' of FIG. 4. FIG. 6 is a cross-sectional view taken along line C-C' of FIG. 4. FIG. 7 is a cross-sectional view taken along line B-B' of FIG. 4.

Referring to FIGS. 4 to 7, in the display device 100 according to an embodiment of the disclosure, a substrate layer SUB, a transistor layer TRL on the substrate layer SUB, a planarization layer PLN on the transistor layer TRL, a light emitting element layer EDL on the planarization layer PLN, an encapsulation layer ENCAP on the light emitting element layer EDL, a touch sensor layer TSL on the encapsulation layer ENCAP, and a color filter layer CFL on the touch sensor layer TSL can be sequentially stacked. In this case, a protective layer, an organic material layer, a polarizing layer, a cover layer, or the like can be additionally disposed on the color filter layer CFL of the display device 100.

In FIGS. 5 and 6, two subpixels emitting light of different wavelengths among the plurality of subpixels SP disposed in the display area DA are illustrated as examples, but the overall structure of the subpixel emitting light of another wavelength can be the same except that the light emissions tack constituting the light emitting element 200 differs.

The substrate layer SUB includes a substrate 110 for supporting and protecting components of the display device disposed thereon.

For example, when the substrate 110 is formed of polyimide PI, moisture can permeate through the substrate 110 formed of polyimide PI and proceed to the thin film transistor or light emitting element, thereby deteriorating the performance of the display device 100. In order to prevent the performance deterioration of the display device 100 due to moisture permeation, the display device 100 according to an embodiment of the disclosure can adopt a double polyimide (PI) structure as the substrate 110.

For example, the substrates 110 can include a first substrate and a second substrate each formed of polyimide (PI), and an inorganic insulation layer formed between the first substrate and the second substrate. The inorganic insulation layer can be formed of a single layer of silicon nitride (SiNx) or silicon oxide (SiOx), or multiple layers thereof. For example, a silicon dioxide (SiO2) material can be used as the inorganic insulation layer, but is not limited thereto, and it can be formed of a double layer of silicon dioxide (SiO2) and silicon nitride (SiNx). The inorganic insulation layer blocks moisture from penetrating into the upper portion of the second substrate. Further, the inorganic insulation layer can block electric charges from affecting the upper thin film transistor 300 through the second substrate when the first substrate is charged with the electric charges. As described above, by blocking the electric charge in the lower polyimide (PI) through the inorganic insulation layer, the reliability of the product can be enhanced, and a process of forming a separate metal layer for blocking the electric charge can be omitted, thereby simplifying the process and reducing the production costs.

As described above in FIG. 1, the substrate 110 can have different structures in the display area DA and the bending area BA. For example, the inorganic insulation layer between the first substrate and the second substrate can be patterned or removed in the bending area BA. When the inorganic insulation layer is disposed in the bending area BA, stress due to bending can be concentrated, and thus a crack can occur in the display device 100.

Further, the substrate layer SUB can include a buffer layer 120 disposed on the substrate 110.

For example, the buffer layer 120 can include a multi-buffer layer disposed on the substrate 110 and an active buffer layer disposed on the multi-buffer layer. A metal layer capable of serving as a light shield can be additionally disposed between the multi-buffer layer and the active buffer layer. This metal layer can be referred to as a light blocking layer.

The thin film transistor 300 including a driving transistor and at least one switching transistor, various patterns for forming at least one capacitor, various insulation films, and various metal patterns can be disposed on the transistor layer TRL.

Referring to FIG. 5, a thin film transistor 300 can be disposed on the buffer layer 120, and the thin film transistor 300 can include an active layer 310, a gate electrode 330, a source electrode 350, and a drain electrode 370. In this case, FIG. 5 illustrates that the drain electrode 370 of the thin film transistor 300 is electrically connected to the anode electrode 210 of the light emitting element 200 to be described below, but the disclosure is not limited thereto. In other words, depending on the design of the pixel driving circuit, the source electrode 350 can be a drain electrode, and the drain electrode 370 can be a source electrode.

The active layer 310 of the thin film transistor 300 can include a channel area in which a channel is formed when the thin film transistor 300 is driven, a source area and a drain area on two opposite sides of the channel area. The source area of the active layer 310 is connected to the source electrode 350, and the drain area is connected to the drain electrode 370. For example, the source area and the drain area can be configured by ion doping (impurity doping) of the active layer 310. In this case, the source area and the drain area can be generated by ion-doping a polysilicon material, and the channel area can mean a portion left as the polysilicon material without ion-doping, but the disclosure is not limited thereto.

The gate insulation layer 130 is disposed on the active layer 310. The gate insulation layer 130 can be disposed on the entire substrate 110 including the active layer 310. For example, the gate insulation layer 130 can be composed of a single layer of silicon nitride (SiNx) or silicon oxide (SiOx), or multiple layers thereof. The gate insulation layer 130 can have a contact hole for connecting the source electrode 350 and the drain electrode 370 of the thin film transistor 300 to the source area and the drain area, respectively, of the active layer 310 of the thin film transistor 300.

The gate electrode 330 of the thin film transistor 300 is disposed on the gate insulation layer 130. For example, the gate electrode 330 can be formed as a single layer or multiple layers formed of molybdenum (Mo), copper (Cu), titanium (Ti), aluminum (Al) chromium (Cr), gold

(Au), nickel (Ni), and neodymium (Nd), or alloys thereof. The gate electrode 330 can be formed on the gate insulation layer 130 to overlap the channel area of the active layer 310 of the thin film transistor 300.

An interlayer insulation layer 140 is disposed on the gate electrode 330. For example, the interlayer insulation layer 140 can be composed of a single layer of silicon nitride (SiNx) or silicon oxide (SiOx), or multiple layers thereof. A contact hole for exposing the source area and the drain area of the active layer 310 of the thin film transistor 300 can be formed in the interlayer insulation layer 140.

The inorganic layer 150 can be disposed on the interlayer insulation layer 140. The inorganic layer 150 can be a passivation layer for protecting the thin film transistor 300 and can be omitted. For example, the inorganic layer 150 can be formed of silicon oxide (SiOx), silicon nitride (SiNx), or multiple layers thereof.

In the planarization layer PLN, a planarization layer 160 including at least one layer is disposed. The planarization layer 160 can be an organic layer for planarizing and protecting the upper portion of the thin film transistor 300. For example, the planarization layer 160 can be formed of an organic material such as acrylic resin, epoxy resin, phenolic resin, polyamide resin, polyimide resin, etc.

Although it is illustrated that the planarization layer 160 is formed of a single layer according to embodiments of the disclosure, the disclosure is not limited thereto. For example, the planarization layer 160 can be formed of a double layer or a triple layer. When the planarization layer 160 is formed of a double layer or a triple layer, a metal layer can be formed between the planarization layers 160. The metal layer between the planarization layers 160 can electrically connect the lower transistor layer TRL and the upper light emitting element layer EDL through the contact hole. The metal layer between the planarization layers 160 can be a connection electrode, but is not limited thereto.

A light emitting element 200 including an anode electrode 210, a light emitting layer 220, and a cathode electrode 230 is disposed on the light emitting element layer EDL. Further, a bank 400 for dividing the emission areas of the plurality of subpixels SP can be disposed on the light emitting element layer EDL.

The anode electrode 210 of the light emitting element 200 is disposed on the planarization layer 160. The anode electrode 210 can be formed of a metallic material, and can be electrically connected to the thin film transistor 300 through a contact hole provided in the planarization layer 160. For example, when the display device 100 according to an embodiment of the disclosure is of a top emission type, the light emitted from the light emitting element 200 is emitted through the upper portion of the substrate 110 and, in this case, the anode electrode 210 can further include a transparent conductive layer and a reflective layer on the transparent conductive layer. For example, the transparent conductive layer can be formed of a transparent conductive oxide such as ITO or IZO, and the reflective layer can be formed of silver (Ag), aluminum (Al), gold (Au), molybdenum (Mo), tungsten (W), chromium (Cr), or an alloy thereof.

The bank 400 is disposed to cover two opposite ends of the anode electrode 210, and a portion of the anode electrode 210 can be exposed. For example, the bank 400 can be formed of an inorganic insulating material such as silicon nitride (SiNx) and silicon oxide (SiOx), or an organic insulating material such as benzocyclobutene resin, acrylic resin, or imide resin, but is not limited thereto. Further, the bank 400 can include a black pigment or a black organic material. For example, the bank 400 can be a black bank.

A spacer can be further disposed on the bank 400.

The light emitting material layer 220 of the light emitting element 200 can be disposed on the anode electrode 210. The light emitting material layer 220 can include a plurality of organic layers. The cathode 230 can be disposed on the light emitting material layer 220 of the light emitting element 200.

An encapsulation layer 500 having a single-layer structure or a multi-layer structure is disposed on the encapsulation layer ENCAP above the light emitting element layer EDL. For example, as illustrated in FIG. 5, the encapsulation layer can include a first encapsulation layer 510, a second encapsulation layer 520, and a third encapsulation layer 530. In this case, the first encapsulation layer 510 and the third encapsulation layer 530 can be formed of an inorganic film, and the second encapsulation layer 520 can be formed of an organic film. Among the first encapsulation layer 510, the second encapsulation layer 520, and the third encapsulation layer 530, the second encapsulation layer 520 can be the thickest and can serve as a planarization layer.

The first encapsulation layer 510 can be disposed closest to the light emitting element 200. In other words, the first encapsulation layer 510 can be disposed on the cathode electrode 230 of the light emitting element 220. The first encapsulation layer 510 can be formed of an inorganic insulating material capable of low temperature deposition. For example, the first encapsulation layer 510 can be silicon nitride (SiNx), silicon oxide (SiOx), silicon oxynitride (SiON), or aluminum oxide (Al2O3). Since the first encapsulation layer 510 is deposited in a low-temperature atmosphere, the first encapsulation layer 510 can prevent the light emitting layer 200 including an organic material vulnerable to a high-temperature atmosphere from being damaged during the deposition process.

The second encapsulation layer 520 can be formed with an area smaller than that of the first encapsulation layer 510. In this case, the second encapsulation layer 520 can be formed to expose two opposite ends of the first encapsulation layer 510. The second encapsulation layer 520 can serve as a buffer to relieve stress between layers due to bending of the flexible display device, and can also serve to enhance planarization performance. For example, the second encapsulation layer 520 can be formed of an organic insulating material such as an acrylic resin, an epoxy resin, polyimide, polyethylene, silicon oxycarbonate (SiOC), or the like. For example, the second encapsulation layer 520 can be formed through an inkjet method, but is not limited thereto.

The third encapsulation layer 530 can be formed on the substrate 110 on which the second encapsulation layer 520 is formed to cover the upper surface and the side surface of each of the second encapsulation layer 520 and the first encapsulation layer 510. In this case, the third encapsulation layer 530 can minimize or block external moisture or oxygen from penetrating into the first encapsulation layer 510 and the second encapsulation layer 520. For example, the third encapsulation layer 530 can be formed of an inorganic insulating material such as silicon nitride (SiNx), silicon oxide (SiOx), silicon oxynitride (SiON), or aluminum oxide (Al2O3).

Although the disclosure illustrates that the first encapsulating layer 510 and the second encapsulating layer 530 are formed of a single layer, the disclosure is not limited thereto. For example, the first encapsulation layer 510 and the third encapsulation layer 530 can be formed as multiple layers including silicon nitride (SiNx), silicon oxide (SiOx), and silicon oxynitride (SiON). Further, the first encapsulating layer 510 and the third encapsulating layer 530 can have different numbers of layers and can have different thicknesses. For example, the first encapsulation layer 510 can be thicker than the third encapsulation layer 530.

As illustrated in FIG. 1, at least one dam 117 can be disposed in the non-display area NA to block the flow of the second encapsulation layer 520 of the encapsulation layer 500.

At least one dam 117 can be formed to include at least one of a bank 400 and a spacer. For example, at least one dam 117 can include a bank 400, and the bank 400 can be a black bank including a black pigment.

The touch insulation layer 600 including insulation films for disposing the touch detection unit can be disposed on the encapsulation layer 500.

The touch buffer layer 610 can prevent damage to the light emitting layer 220 that is vulnerable to chemical liquid or moisture. When the touch sensor layer TSL is formed, there can be a chemical liquid (such as a developer or an etchant) used in the process or moisture from the outside. Accordingly, by disposing the touch buffer layer 610 and disposing the touch detection unit thereon, it is possible to prevent chemical liquid or moisture from penetrating into the light emitting material layer 220 including the organic material during the manufacturing process of the touch detection unit. Further, the touch buffer layer 610 can prevent damage to the light emitting material layer 220 including the organic material vulnerable to high temperatures. In this case, the touch buffer layer 610 can be formed at a low temperature below a predetermined temperature e.g., 100°C and can be formed of an organic insulating material having a low dielectric constant of 1 to 3. For example, the touch buffer layer 610 can be formed of an acrylic-based, epoxy-based, or siloxane-based material. As described above, the touch buffer layer 610 is formed of an organic insulating material to prevent damage to the encapsulation layer ENCAP due to bending of the flexible display device.

A touch interlayer insulation layer 620 can be formed on the touch buffer layer 610. The touch interlayer insulation layer 620 can include an organic material. For example, the touch interlayer insulation layer 620 can be an organic layer formed of an organic material, but is not limited thereto. For example, the touch interlayer insulation layer 620 can be an inorganic layer formed of an inorganic material. As the touch interlayer insulation layer 620 is formed of an organic material, the touch interlayer insulation layer 620 can be thicker than the first encapsulation layer 510 or the third encapsulation layer 530.

A protective layer 630 can be formed on the touch interlayer insulation layer 620. For example, the protective layer 630 can be an inorganic layer formed of an inorganic material. The touch interlayer insulation layer 620 can be thicker than the protective layer 630.

The protective layer 630 prevents damage to electrodes of the touch detection unit from chemical liquid (e.g., a developer) or moisture used in the process for the upper layer.

A plurality of color filters 720 and a black matrix BM between the plurality of color filters 720 on a plane are disposed in the color filter layer CFL on the touch sensor layer TSL.

Color filters 720_A and 720_B and a black matrix BM can be disposed on the protective layer 630.

The black matrix BM can be disposed on the protective layer 630 to overlap the bank 400, and the plurality of color filters 720 can be disposed to overlap the opening of the black matrix BM. The color filter 720 reduces the likelihood that external light from the outside is incident on, e.g., the bank 400 and is reflected to be recognized, without blocking the light emitted from the light emitting element 200, thereby maintaining light efficiency. The black matrix BM is positioned to overlap the edge of the emission area of the light emitting element 200 to reduce the external light incident into the emission area by absorbing the incident external light and preventing the reflected light from being visually recognized. When the bank 400 includes a black material, reflection of external light incident from the outside can be reduced.

The touch sensor layer TSL can be disposed on the encapsulation layer ENCAP. The touch sensor layer TSL can include a first sensor electrode layer SEL1 and a second sensor electrode layer SEL2 on the first sensor electrode layer SEL1.

Referring to FIG. 5, the first sensor electrode SE1 can be formed of the same layer as the first sensor electrode layer SEL1. The first sensor electrode layer SEL1 can be formed between the touch buffer layer 610 and the touch interlayer insulation layer 620.

On the other hand, referring to FIG. 6, the second sensor electrode SE2 can be formed of the same layer as the second sensor electrode layer SEL2. The second sensor electrode layer SEL2 can be formed between the touch interlayer insulation layer 620 and the protective layer 630.

Referring to both FIGS. 5 and 6, a black matrix BM can be formed on the first sensor electrode SE1 and the second sensor electrode SE2. The black matrix BM can be formed to overlap the first sensor electrode SE1 and the second sensor electrode SE2.

For example, in FIG. 6, when light from the outside is reflected through the second sensor electrode SE2, the black matrix BM can be damaged by the reflected external light. For example, in the process of patterning the black matrix BM through exposure, if the black matrix BM does not include a margin in an area other than the area overlapping the second sensor electrode SE2, the black matrix BM can be over-cured by the reflected external light, resulting in an undercut.

The first sensor electrode SE1 can be formed of the same layer as the first sensor electrode layer SEL1, and the first sensor electrode SE1 can be disposed to be spaced apart from the black matrix BM by a distance corresponding to the touch interlayer insulation layer 620. On the other hand, the second sensor electrode SE2 can be formed of the same layer as the second sensor electrode layer SEL2, and the second sensor electrode SE2 can be formed on the touch interlayer insulation layer 620 so as not to be spaced apart from the black matrix BM by the distance corresponding to the touch interlayer insulation layer 620.

As the second sensor electrode SE2 is closer to the black matrix BM than the first sensor electrode SE1, when the touch electrode is formed with the second sensor electrode SE2 formed on the second sensor electrode layer SEL2, the margin of the black matrix BM should be larger than when the touch electrode is formed with the first sensor electrode SE1 formed on the first sensor electrode layer SEL1.

The display device according to the disclosure includes both the second sensor electrode SE2 in the second sensor electrode layer SEL2 and the first sensor electrode SE1 in the first sensor electrode layer SEL1 in the sensor electrode forming the touch electrode, thereby increasing the degree of freedom in design of the black matrix BM.

Further, the display device according to the disclosure includes the sensor electrode in the first sensor electrode layer SEL1, thereby minimizing the margin of the black matrix BM and increasing the opening of the black matrix BM to increase luminous efficiency.

For example, the width of the black matrix corresponding to the first sensor electrode SE1 formed of the first sensor electrode layer SEL1 can be smaller than the width of the black matrix corresponding to the second sensor electrode SE2 formed of the second sensor electrode layer SEL2.

In other words, an overlapping ratio of the black matrix corresponding to the first sensor electrode SE1 and the first sensor electrode SE1 can be larger than an overlapping ratio between the black matrix corresponding to the second sensor electrode SE2 and the second sensor electrode SE2.

The overlapping ratio of the black matrix corresponding to the sensor electrode and the sensor electrode can be defined as (width of the sensor electrode) / (width of the black matrix corresponding to the sensor electrode).

As another example, the black matrix BM can include a first portion overlapping the first sensor electrode SE1 and the third sensor electrode SE3, and can include a second portion overlapping the second sensor electrode SE2 and the fourth sensor electrode.

A length of a first portion where the first sensor electrode SE1 and the third sensor electrode SE3 overlap the black matrix BM can be referred to as a first width, and a length of a second portion where the second sensor electrode SE2 and the fourth sensor electrode SE4 overlap the black matrix BM can be referred to as a second width.

In this case, e.g., the first width can be smaller than the second width.

In other words, the black matrix overlapping ratio of the first/second portion can be defined as (the first/second width of the first/second portion) / (the width of the black matrix corresponding to the sensor electrode).

Referring to FIG. 7, the second sensor electrode SE2 and the fourth sensor electrode SE4 can be electrically connected through a third sensor electrode SE3. The third sensor electrode SE3 can be formed of a first touch metal TM1, and the second sensor electrode SE2 and the fourth sensor electrode SE4 can be formed of a second touch metal TM2.

A touch interlayer insulation layer 620 can be formed between the second sensor electrode SE2 and the third sensor electrode SE3. A touch interlayer insulation layer 620 can be formed between the fourth sensor electrode SE4 and the third sensor electrode SE3. The second sensor electrode SE2 and the third sensor electrode SE3 can be electrically connected to each other by a contact hole formed in the touch interlayer insulation layer 620. The fourth sensor electrode SE4 and the third sensor electrode SE3 can be electrically connected to each other by another contact hole formed in the touch interlayer insulation layer 620. The second sensor electrode SE2 and the fourth sensor electrode SE4 can be formed of a second sensor electrode layer SEL2 formed of a second touch metal TM2, and the third sensor electrode SE3 can be formed of a first sensor electrode layer SEL1 formed of a first touch metal TM1.

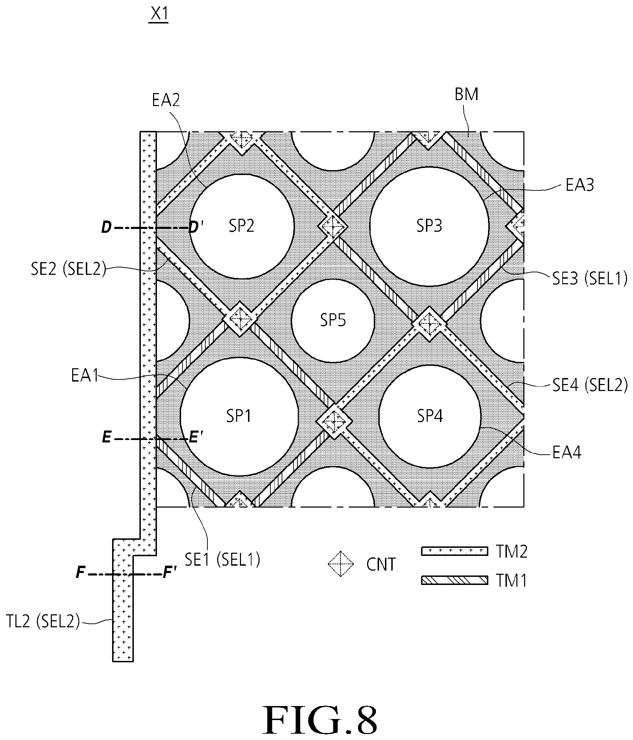

FIG. 8 is a plan view illustrating a display device according to an embodiment of the disclosure.

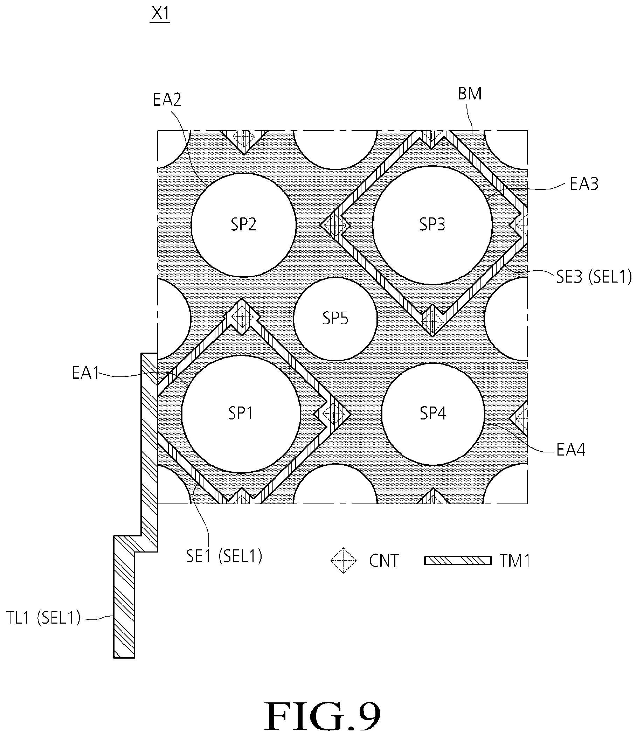

FIG. 9 is a plan view illustrating a display device according to an embodiment of the disclosure.

Referring to FIGS. 8 and 9, the display device 100 can include a touch routing line TL outside the display area DA. The touch routing line TL can be disposed in the non-display area NA. The touch routing line TL can include a lower touch routing line TL1 and an upper touch routing line TL2.

The lower touch routing line TL1 can be formed of the same layer as the first sensor electrode layer SEL1, and the upper touch routing line TL2 can be formed of the same layer as the second sensor electrode layer SEL2.

Referring to FIG. 8, a first sensor electrode SE1 and a third sensor electrode SE3 formed of the same layer as the first sensor electrode layer SEL1 can be disposed in the first emission area EA1 corresponding to the first subpixel SP1 and the third emission area EA3 corresponding to the third subpixel SP3, respectively.

As illustrated in FIG. 3, the touch electrode TE can include a plurality of sensor electrodes SE. The first sensor electrode SE1 and the second sensor electrode SE2 can be connected to the same touch routing line TL. For example, when the first sensor electrode SE1 is formed of the same layer as the first sensor electrode layer SEL1, and the second sensor electrode SE2 is formed of the same layer as the second sensor electrode layer SEL2, the touch routing line TL can be connected in the same layer as the first sensor electrode SE1 and the first sensor electrode layer SEL1, and can be connected in the same layer as the second sensor electrode layer SE2 and the second sensor electrode layer SEL2. For example, the touch routing line TL can include a lower touch routing line TL1 and an upper touch routing line TL2. For example, the touch routing line TL can be a double routing line. A detailed connection structure between the touch routing line and the touch electrode is described below.

Referring to FIG. 9, the lower routing line TL1 can be formed of the same layer as the first sensor electrode layer SEL1. The lower routing line TL1 can be formed together with the first sensor electrode SE1 and the third sensor electrode SE3. The first sensor electrode SE1 can be connected to the touch routing line TL in the first sensor electrode layer SEL1. For example, the first sensor electrode SE1 can be connected to the lower routing line TL1 in the first sensor electrode layer SEL1, and the second sensor electrode SE2 can be connected to the upper routing line TL2 in the second sensor electrode layer SEL2. In other words, the first sensor electrode SE1 can be connected to the touch routing line TL in the first sensor electrode layer SEL1, and the second sensor electrode SE2 can be connected to the touch routing line TL in the second sensor electrode layer SEL2.

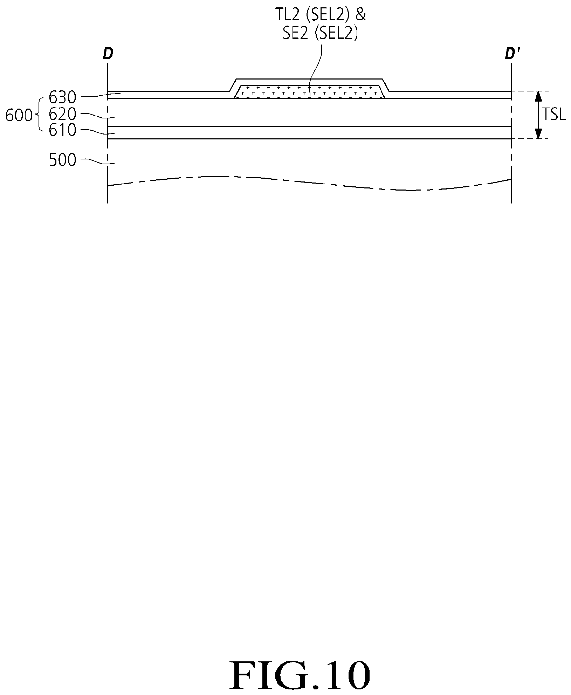

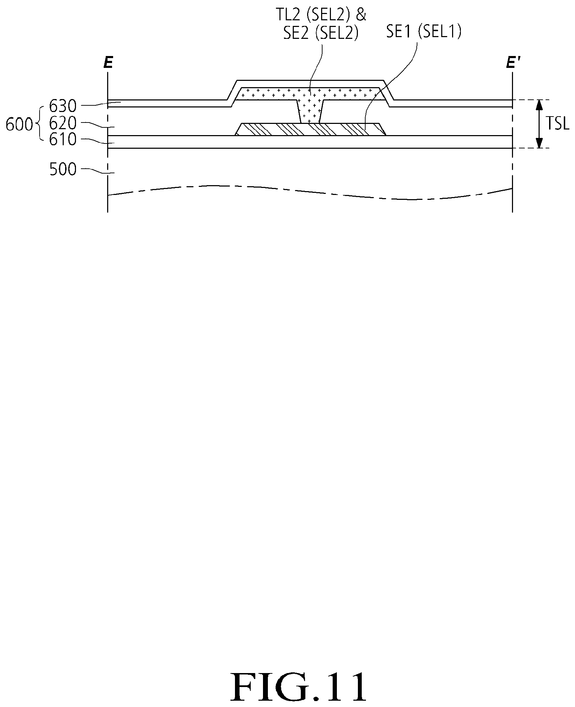

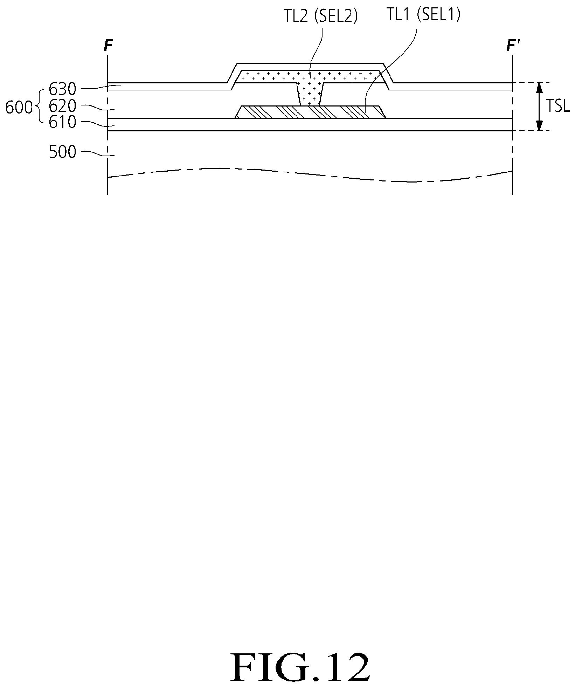

FIG. 10 is a cross-sectional view taken along line D-D' of FIG. 8. FIG. 11 is a cross-sectional view taken along line E-E' of FIG. 8. FIG. 12 is a cross-sectional view taken along line F-F' of FIG. 8.

Referring to FIGS. 10 to 12, the touch sensor layer TSL can include a touch buffer layer 610, a first sensor electrode layer SEL1, a touch interlayer insulation layer 620, a second sensor electrode layer SEL2, and a protective layer 630.

The touch routing line TL can have a double line structure including a lower touch routing line TL1 and an upper touch routing line TL2. The lower touch routing line TL1 and the upper touch routing line TL2 can be electrically connected to each other.

Referring to FIG. 10, lines D-D' are a cut line of an area in which the second sensor electrode SE2 and the second touch routing line TL2 are connected. For example, the second sensor electrode SE2 and the upper touch routing line TL2 can be connected to each other in the second sensor electrode layer SEL2. As another example, the second sensor electrode SE2 and the upper touch routing line TL2 can be integrally formed in the second sensor electrode layer SEL2. The second sensor electrode layer SEL2 can be between the touch interlayer insulation layer 620 and the protective layer 630.

Referring to FIG. 11, the line E-E' is a cut line of an area in which the first sensor electrode SE1 and the lower touch routing line TL1 are connected. For example, the first sensor electrode SE1 and the lower touch routing line TL1 can be connected to each other in the first sensor electrode layer SEL1. As another example, the first sensor electrode SE1 and the lower touch routing line TL1 can be integrally formed in the first sensor electrode layer SEL1. The first sensor electrode layer SEL1 can be between the touch buffer layer 610 and the touch interlayer insulation layer 620. The upper touch routing line TL2 formed of the second sensor electrode layer SEL2 can be disposed on the lower touch routing line TL1 formed of the first sensor electrode layer SEL1. The first touch routing line TL1 formed of the first sensor electrode layer SEL1 and the second touch routing line TL2 formed of the second sensor electrode layer SEL2 can be electrically connected through a hole in the touch interlayer insulation layer 620.

Referring to FIG. 12, the line F-F' is a cut line of the touch routing line TL. As described above, the touch routing line TL can include a lower touch routing line TL1 and an upper touch routing line TL2. The lower touch routing line TL1 and the upper touch routing line TL2 can be formed with a touch interlayer insulation layer 620 interposed therebetween. The lower touch routing line TL1 and the upper touch routing line TL2 can be connected to each other through a contact hole formed in the touch interlayer insulation layer 620. For example, the touch routing line TL can be a double layer.

A display device according to embodiments of the disclosure can comprise a substrate including a display area and a non-display area outside the display area, a thin film transistor on the substrate, a subpixel connected to the thin film transistor, an encapsulation layer disposed on the subpixel, a first sensor electrode disposed on the encapsulation layer, a touch interlayer insulation layer disposed on the first sensor electrode, and a second sensor electrode disposed on the touch interlayer insulation layer and electrically connected to the first sensor electrode through a contact hole of the touch interlayer insulation layer.

According to one or more embodiments of the disclosure, a size of an area of the first sensor electrode can correspond to a size of an area of the second sensor electrode. For example, a shape of the first sensor electrode can be identical to a shape of the second sensor electrode. As another example, a difference between the size of the first sensor electrode area and the size of the second sensor electrode area can be within a predetermined value. This can mean that even when the first sensor electrode and the second sensor electrode are disposed in different metal layers, the first sensor electrode and the second sensor electrode are actual touch sensors in which capacitance for touch sensing is formed.

According to one or more embodiments of the disclosure, a shape of the first sensor electrode can be identical to a shape of the second sensor electrode.

According to one or more embodiments of the disclosure, the encapsulation layer can include a first encapsulation layer, a second encapsulation layer on the first encapsulation layer, and a third encapsulation layer on the second encapsulation layer. The first encapsulation layer and the third encapsulation layer can include an inorganic material. A thickness of the touch interlayer insulation layer can be larger than a thickness of the first encapsulation layer and a thickness of the third encapsulation layer.

According to one or more embodiments of the disclosure, the touch interlayer insulation layer can include an organic material.

According to one or more embodiments of the disclosure, the display device can further comprise a bank partitioning the subpixel. The bank can include a black bank.

According to one or more embodiments of the disclosure, the display device can further comprise a third sensor electrode disposed to be spaced apart from the first sensor electrode and a fourth sensor electrode disposed to be spaced apart from the second sensor electrode. The first sensor electrode and the third sensor electrode can be formed of a first sensor electrode layer. The second sensor electrode and the fourth sensor electrode can be formed of a second sensor electrode layer. In other words, the first sensor electrode and the third sensor electrode can be disposed in the first sensor electrode layer, and the second sensor electrode and the fourth sensor electrode can be disposed in the second sensor electrode layer.

According to one or more embodiments of the disclosure, the first to fourth sensor electrodes can be electrically connected to form one mesh-shaped touch electrode.

According to one or more embodiments of the disclosure, the subpixel can include a first subpixel surrounded by the first sensor electrode, a second subpixel surrounded by the second sensor electrode, a third subpixel surrounded by the third sensor electrode, and a fourth subpixel surrounded by the fourth sensor electrode. The first to fourth subpixels can correspond to first emission area to fourth emission area, respectively.

According to one or more embodiments of the disclosure, the display device can further comprise a fifth subpixel surrounded by the first to fourth sensor electrodes. The fifth subpixel can correspond to a fifth emission area.

According to one or more embodiments of the disclosure, a size of the fifth emission area can be smaller than a size of each of the first to fourth emission areas.

According to one or more embodiments of the disclosure, the display device can further comprise a black matrix on the second sensor electrode layer.

According to one or more embodiments of the disclosure, the black matrix can have a first width in a first portion overlapping the first sensor electrode and the third sensor electrode and a second width in a second portion overlapping the second sensor electrode and the fourth sensor electrode. The first width can be smaller than the second width.

According to one or more embodiments of the disclosure, a black matrix overlapping ratio of the first portion can be larger than a black matrix overlapping ratio of the second portion.

According to one or more embodiments of the disclosure, the display device can further comprise a touch routing line electrically connected to the first sensor electrode and the second sensor electrode. The touch routing line can include the same layer as at least one of the first sensor electrode layer and the second sensor electrode layer.

A display device according to embodiments of the disclosure can comprise a substrate, a plurality of sensor electrodes, and a black matrix on the plurality of sensor electrodes. The black matrix can include a first portion having a first width and a second portion having a second width larger than the first width. The plurality of sensor electrodes can include a first sensor electrode overlapping the first portion and a second sensor electrode overlapping the second portion. The first sensor electrode can be positioned closer to the substrate than the second sensor electrode.

According to one or more embodiments of the disclosure, a size of an area of the first sensor electrode can correspond to a size of an area of the second sensor electrode.

According to one or more embodiments of the disclosure, a shape of the first sensor electrode can be identical to a shape of the second sensor electrode.

According to one or more embodiments of the disclosure, the display device can further comprise a touch interlayer insulation layer between the first sensor electrode and the second sensor electrode. The touch interlayer insulation layer can include an organic material.

According to one or more embodiments of the disclosure, the display device can further comprise a third sensor electrode disposed to be spaced apart from the first sensor electrode and a fourth sensor electrode disposed to be spaced apart from the second sensor electrode. The third sensor electrode can be disposed on the same layer as the first sensor electrode, and the fourth sensor electrode can be disposed on the same layer as the second sensor electrode.

According to one or more embodiments of the disclosure, the first to fourth sensor electrodes can be electrically connected to form one mesh-shaped touch electrode.

According to one or more embodiments of the disclosure, the display device can further comprise a subpixel between the substrate and the black matrix. The subpixel can include a first subpixel surrounded by the first sensor electrode, a second subpixel surrounded by the second sensor electrode, a third subpixel surrounded by the third sensor electrode, and a fourth subpixel surrounded by the fourth sensor electrode. The first to fourth subpixels can correspond to first emission area to fourth emission area, respectively.

According to one or more embodiments of the disclosure, the display device can further comprise a fifth subpixel surrounded by the first to fourth sensor electrodes. The fifth subpixel can correspond to a fifth emission area.

According to one or more embodiments of the disclosure, a size of the fifth emission area can be smaller than a size of each of the first to fourth emission areas.

According to one or more embodiments of the disclosure, a black matrix overlapping ratio of the first portion can be larger than a black matrix overlapping ratio of the second portion.

According to one or more embodiments of the disclosure, the display device can further comprise a touch routing line electrically connected to the first sensor electrode and the second sensor electrode. The touch routing line can be disposed on the same layer as at least one of the first sensor electrode and the second sensor electrode.

The above-described embodiments are merely examples, and it will be appreciated by one of ordinary skill in the art various changes can be made thereto without departing from the scope of the disclosure. Accordingly, the embodiments set forth herein are provided for illustrative purposes, but not to limit the scope of the disclosure, and should be appreciated that the scope of the disclosure is not limited by the embodiments.

## Claims

1. A display device, comprising:
a substrate including a display area and a non-display area outside the display area;
a thin film transistor disposed on the substrate;
a subpixel connected to the thin film transistor;
an encapsulation layer disposed on the subpixel;
a first sensor electrode disposed on the encapsulation layer;
a touch interlayer insulation layer disposed on the first sensor electrode; and
a second sensor electrode disposed on the touch interlayer insulation layer and electrically connected to the first sensor electrode through a contact hole of the touch interlayer insulation layer.

2. The display device of claim 1, wherein a size of an area of the first sensor electrode corresponds to a size of an area of the second sensor electrode.

3. The display device of claim 1 or 2, wherein a shape of the first sensor electrode is identical to a shape of the second sensor electrode.

4. The display device of any preceding claim, wherein the encapsulation layer includes:
a first encapsulation layer;
a second encapsulation layer on the first encapsulation layer; and
a third encapsulation layer on the second encapsulation layer,
wherein the first encapsulation layer and the third encapsulation layer include an inorganic material, and
wherein a thickness of the touch interlayer insulation layer is larger than a thickness of the first encapsulation layer and a thickness of the third encapsulation layer.

5. The display device of claim 4, wherein the touch interlayer insulation layer includes an organic material.

6. The display device of any preceding claim, further comprising a bank partitioning the subpixel, wherein the bank includes a black bank.

7. The display device of any preceding claim, further comprising:
a third sensor electrode disposed to be spaced apart from the first sensor electrode; and
a fourth sensor electrode disposed to be spaced apart from the second sensor electrode,
wherein the first sensor electrode and the third sensor electrode are formed of a first sensor electrode layer, and
wherein the second sensor electrode and the fourth sensor electrode are formed of a second sensor electrode layer.

8. The display device of claim 7, wherein the first to fourth sensor electrodes are electrically connected to form one mesh-shaped touch electrode.

9. The display device of claim 7 or 8, wherein the subpixel includes:
a first subpixel surrounded by the first sensor electrode;
a second subpixel surrounded by the second sensor electrode;
a third subpixel surrounded by the third sensor electrode; and
a fourth subpixel surrounded by the fourth sensor electrode, and
wherein the first to fourth subpixels correspond to a first emission area to a fourth emission area, respectively.

10. The display device of claim 9, further comprising a fifth subpixel surrounded by the first to fourth sensor electrodes, wherein the fifth subpixel corresponds to a fifth emission area.

11. The display device of claim 10, wherein a size of the fifth emission area is smaller than a size of each of the first to fourth emission areas.

12. The display device of any of claims 7 to **11,** further comprising a black matrix on the second sensor electrode layer.

13. The display device of claim 12, wherein the black matrix has a first width in a first portion overlapping the first sensor electrode and the third sensor electrode, and a second width in a second portion overlapping the second sensor electrode and the fourth sensor electrode, and
wherein the first width is smaller than the second width.

14. The display device of claim 13, wherein a black matrix overlapping ratio of the first portion is larger than a black matrix overlapping ratio of the second portion.

15. The display device of any preceding claim, further comprising a touch routing line electrically connected to the first sensor electrode and the second sensor electrode,
wherein the touch routing line includes a same layer as at least one of the first sensor electrode and the second sensor electrode.
